(19) Europäisches Patentamt
European Patent Office
Office européen des brevets

(11) Veröffentlichungsnummer : **0 501 919 A1**

(12) # EUROPÄISCHE PATENTANMELDUNG

(21) Anmeldenummer : **92810124.5**

(51) Int. Cl.[5] : **G03F 7/004,** G03F 7/038

(22) Anmeldetag : **20.02.92**

(30) Priorität : **01.03.91 CH 625/91**

(43) Veröffentlichungstag der Anmeldung : **02.09.92 Patentblatt 92/36**

(84) Benannte Vertragsstaaten : **AT BE CH DE FR GB IT LI NL**

(71) Anmelder : **CIBA-GEIGY AG**
**Klybeckstrasse 141**
**CH-4002 Basel (CH)**

(72) Erfinder : **Schädeli, Ulrich, Dr.**
**Im Hubel**
**CH-1737 Plasselb (CH)**

(54) **Strahlungsempfindliche Zusammensetzungen auf der Basis von Polyphenolen und Acetalen.**

(57) Es werden strahlungsempfindliche Zusammensetzungen enthaltend
a) mindestens ein festes filmbildendes Polyphenol,
b) mindestens eine Verbindung der Formel I

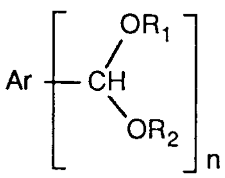

(I),

worin
n 2, 3 oder 4 darstellt,
Ar ein n-wertiger Benzol- oder Naphthalinrest oder ein zweiwertiger Rest der Formel II

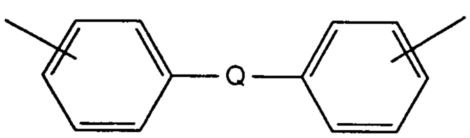

(II) ist,

Q die direkte Bindung, -O-, -SO-, $-SO_2-$, $-CH_2-$, $-C(CH_3)(Phenyl)-$ oder $-C(CH_3)_2-$ ist, $R_1$ und $R_2$ unabhängig voneinander $C_1$-$C_8$-Alkyl oder unsubstituiertes oder durch $C_1$-$C_4$-Alkyl substituiertes Phenyl oder Naphthyl bedeuten oder $R_1$ und $R_2$ zusammen 1,2-Phenylen oder $-[C(R')(R'')]_m-$ darstellen,
R′ und R″ unabhängig voneinander Wasserstoff, $C_1$-$C_4$-Alkyl oder Phenyl sind und m 2, 3 oder 4 ist, und.
c) mindestens eine unter aktinischer Strahlung säurebildende Verbindung beschrieben.
Diese Zusammensetzungen finden Anwendung als Negativresist, insbesondere zur Herstellung von Druckplatten, gedruckten Schaltungen und integrierten Schaltkreisen.

EP 0 501 919 A1

Die vorliegende Erfindung betrifft strahlungsempfindliche Zusammensetzungen auf der Basis von festen filmbildenden Polyphenolen, einem Säuregenerator und bestimmten Acetalen, sowie deren Verwendung als Negativresist zur Herstellung von Schutzschichten und Reliefstrukturen.

Aus der Literatur sind nach dem Prinzip der sogenannten chemischen Ampflifikation arbeitende Negativresist-Zusammensetzungen bekannt. So beschreiben J.M.J. Fréchet et al. in Polym. Mat. Sci-Eng., 60 (1989) 147-150 Negativresists des Amplifikationstyps basierend auf elektrophiler aromatischer Substitution. Dabei werden u.a. 3-Komponentensysteme aus mehrfunkrionellen niedermolekularen latenten Elektrophilen, wie 1,4-Bis-(acetyloxymethyl)benzol, einem säurebildenden Triarylsulfoniumsalz, wie z.B. Triphenylsulfonium-hexafluorantimonat, und einem phenolischen Polymer, z.B. einem Poly(4-hydroxystyrol) oder einem Novolak, mit UV-Licht bei 254 nm bestrahlt, wobei die bestrahlten Stellen vernetzt werden. Ähnliche Negativresist-Systeme sind aus der US-A 4,800,152 bekannt, wobei u.a. Trisacetoxymesitylen als latentes Elektrophil (Vernetzer) verwendet wird.

K.A. Graziano et al. beschreiben in Polym. Mat. Sci. Eng., 60 (1989) 151-154 säurekatalysierte Negativresist-Zusammensetzungen auf der Basis von Novolaken, einem strahlungsempfindlichen Säuregenerator und Melaminmethylolethern als Vernetzer.

Andererseits ist bekannt, dass sich durch Säure spaltbare monomere oder polymere Acetale und Ketale zusammen mit photoaktivierbaren säurebildenden Verbindungen und gegebenenfalls Bindemitteln zur Herstellung von positiv arbeitenden Photoresistsystemen eignen (s. z.B. DE-A 2 718 254, US-A 3,779,778 und EP-A 0 202 196).

Es wurde nun gefunden, dass Zusammensetzungen auf der Basis von festen filmbildenden Polyphenolen, einem Säuregenerator und bestimmten Acetalen überraschenderweise als nach dem Prinzip der chemischen Amplifikation arbeitende Negativresistsysteme verwendet werden können.

Gegenstand der Erfindung sind daher strahlungsempfindliche Zusammensetzungen enthaltend

a) mindestens ein festes filmbildendes Polyphenol,

b) mindestens eine Verbindung der Formel I

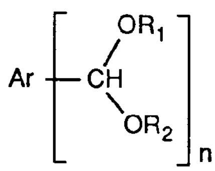

(I),

worin

n 2, 3 oder 4 darstellt,

Ar ein n-wertiger Benzol- oder Naphthalinrest oder ein zweiwertiger Rest der Formel II

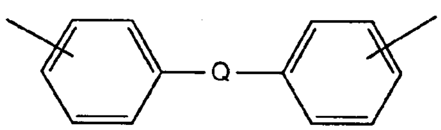

(II) ist,

Q die direkte Bindung, -O-, -SO-, $-SO_2-$, $-CH_2-$, $-C(CH_3)(Phenyl)-$ oder $-C(CH_3)_2-$ ist, $R_1$ und $R_2$ unabhängig voneinander $C_1$-$C_8$-Alkyl oder unsubstituiertes oder durch $C_1$-$C_4$-Alkyl substituiertes Phenyl oder Naphthyl bedeuten oder $R_1$ und $R_2$ zusammen 1,2-Phenylen oder $-[C(R')(R'')]_m-$ darstellen,

R'und R'' unabhängig voneinander Wasserstoff, $C_1$-$C_4$-Alkyl oder Phenyl sind und m 2, 3 oder 4 ist, und

c) mindestens eine unter aktinischer Strahlung säurebildende Verbindung.

Als zwei- bis vierwertige Benzol- und Nahphthalinreste Ar kommen beispielsweise 1,3- und 1,4-Phenylen, Benzol- 1,2,3-triyl, Benzol- 1,2,4-triyl, Benzol- 1,3,5-triyl, Benzol-1,2,4,5-tetrayl, 1,4-, 1,5-, 2,6- und 2,7-Nahphtylen, Naphthalin- 1,2,5-triyl, Naphthalin1,4,5-triyl und Naphthalin- 1,4,5-8-tetrayl in Betracht. Reste der Formel II sind vorzugsweise in 3,3'- und insbesondere in 4,4'-Stellung gebunden.

Q ist bevorzugt die direkte Bindung, $-CH_2-$ oder $-SO_2-$.

Besonders bevorzugt ist Ar ein n-wertiger Benzolrest, ganz besonders bevorzugt 1,3-Phenylen und vor allem 1,4-Phenylen (n = 2).

Durch $R_1$, $R_2$, R' oder R'' dargestellte Alkylgruppen oder darin enthaltene Alkylsubstituenten können geradkettig oder verzweigt sei. Als Beispiele seien erwähnt: Methyl, Ethyl, Propyl, Isopropyl, n-, sec. und tert.Butyl

sowie - für $R_1$ und $R_2$ - auch n-Pentyl, 2-Methylpentyl, n-Hexyl, n-Heptyl und n-Octyl.

Phenyl- und Naphthylgruppen $R_1$ und $R_2$ können ein- bis dreifach mit $C_1$-$C_4$-Alkyl, besonders Methyl oder Ethyl, substituiert sein. Bevorzugt sind solche Reste mit einer oder zwei Methyl- oder Ethylgruppen substituiert. Besonders bevorzugt sind jedoch unsubstituiertes Naphthyl und besonders unsubstituiertes Phenyl. R′ und/oder R″ sind vorzugsweise Wasserstoff oder Methyl.

$R_1$ und $R_2$ haben vorzugsweise dieselbe Bedeutung und sind insbesondere $C_1$-$C_4$-Alkyl. Besonders bevorzugt stellen sie zusammen 1,2-Phenylen und insbesondere $-[C(R')(R'')]_m-$ mit R′ und/oder R″ = H oder Methyl und m = 2 oder 3 dar.

Die Verbindungen der Formel I werden zweckmässig in einer Menge von 5-50 Gew.%, bevorzugt 10-30 Gew.%, bezogen auf die Komponente a), verwendet.

Die Verbindungen der Formel I sind bekannt oder können auf an sich bekannte Weise hergestellt werden, z.B. durch Umsetzung der entsprechenden Aldehyde der Formel Ia

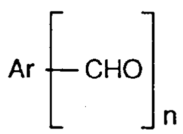

(Ia)

mit Brenzkatechin, Monohydroxyverbindungen $HOR_1$ und $HOR_2$ oder Dihydroxyverbindungen $HO-[C(R')(R'')]_m-OH$, wobei Ar, n, $R_1$, $R_2$, R′, R″ und m die oben angegebene Bedeutung haben.

Die Aldehyde der Formel Ia sind ebenfalls bekannt oder können nach an sich bekannten Methoden erhalten werden, z.B. durch

1. Reduktion der entsprechenden Carbonsäuren mit Ameisensäure in Gegenwart eines Katalysators, wie $MnCO_3$,
2. katalytische Hydrierung der entsprechenden Carbonsäurechloride, z.B. mit Pd auf $BaSO_4$ und gegebenenfalls in Gegenwart geringer Mengen Chinolin (Rosenmund-Reduktion),
3. Oxidation der entsprechenden Hydroxymethylverbindungen,
4. Oxidation der entsprechenden Aminomethylverbindungen in Gegenwart von Kupfer,
5. durch Sommelet-Reaktion der entsprechenden Chlormethylverbindungen (mit Ausnahme der o-Dialdehyde).

Verbindungen der Formel Ia, worin Ar einen zwei- bis vierwertigen Benzol- oder Naphthalinrest bedeuten, werden bevorzugt aus den entsprechenden Carbonsäuren oder Carbonsäuechloriden hergestellt.

Verbindungen der Formel Ia, worin Ar einen zweiwertigen Rest der Formel

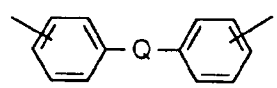

bedeutet, werden zweckmässig aus den entsprechenden Bis(hydroxymethyl)- oder Bis(aminomethyl)verbindungen hergestellt. Dabei befinden sich die Hydroxymethyl- oder Aminomethylgruppen bevorzugt in 3,3′- und insbesondere in 4,4′-Stellung.

Das Bindemittel a) ist ein festes, filmbildendes Polyphenol, d.h. ein Polymer, das einen bestimmten Gehalt an phenolischen Hydroxylgruppen aufweist. Dieser sollte zumindest so hoch sein, dass die Entwicklung oder zumindest die Quellung in einer wässrig alkalischen Entwicklerlösung gewährleistet ist.

Geeignete alkalisch-wässrig lösliche, filmbildende Bindemittel a) lassen sich im allgemeinen in folgende Gruppen einteilen:

i) Novolake aus mindestens einem Phenol und mindestens einem Aldehyd,
ii) Homo- und Copolymere von Alkenylphenolen und
iii) Homo- und Copolymere von N-Hydroxyphenylmaleinirniden.

Bevorzugt wird dabei die Gruppe ii).

Bevorzugte Novolake i) sind Verbindungen, die sich von einem $C_1$-$C_6$-Aldehyd, beispielsweise Formaldehyd und Acetaldehyd, und von einem zweikernigen, bevorzugt jedoch einkernigen, gegebenenfalls substituierten Phenol ableiten. Beispiele für bevorzugte Phenole sind Phenol selbst oder mit ein oder zwei $C_1$-$C_9$-Alkylgruppen substituierte Phenole, wie beispielsweise o-, m- oder p-Kresol, Xylenol, p-tert.Butylphenol und o-, m- oder p-Nonylphenol, oder mit ein oder zwei Halogenatomen, bevorzugt Chlor oder Brom, substituierte Phenole, beispielsweise p-Chlorphenol, mit einem Phenylkern substituierte Phenole, wie z.B. p-Phenylphenol, oder auch Phenole mit mehr als einer phenolischen Gruppe, wie z.B Resorcin, Bis-(4-hydroxyphenyl)methan oder 2,2-Bis-(4-hydroxyphenyl)propan.

Bevorzugte Homo- oder Copolymere von Alkenylphenolen ii) sind insbesondere solche mit wiederkehrenden S truktwelementen der Formel III

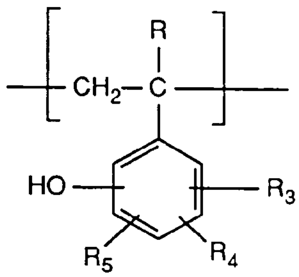

(III),

worin R Wasserstoff oder Methyl ist, $R_3$, $R_4$ und $R_5$ unabhängig voneinander Wasserstoff, $C_1$-$C_4$-Alkyl, $C_1$-$C_4$-Alkoxy, Halogen, insbesondere Chlor oder Brom, oder Methylol bedeuten. Die phenolische Hydroxylgruppe ist in o-, m- oder p-Stellung zur Alkenylgruppe angeordnet, bevorzugt jedoch in p-Stellung.

Als Comonomere kommen beispielsweise carboxylgruppenfreie Vinylmonomere in Betracht. Beispiele für solche Monomere sind Styrol, Acryl- und Methacrylsäureester, insbesondere (Meth)acrylsäuremethylester oder (Meth)acrylsäure-2-hydroxyethylester, Acrylamid, Vinylacetat und N-substituierte Maleinimide.

Dei Comonomerenanteil der Bindemittel des Typs ii) beträgt bevorzugt 0-50 Mol%, bezogen auf das Gesamtpolymere.

Polymere des Typs ii) sind bekannt und beispielsweise in der DE-A 2 322 230 und in der EP-A 153,682 beschrieben. Teilweise sind solche Polymere auch im Handel erhältlich.

Bevorzugte Bindemittel des Typs iii) sind Homopolymere von N-Hydroxyphenylmaleinimiden. Dabei handelt es sich bevorzugt um Homopolymere mit der Struktureinheit der Formel IV

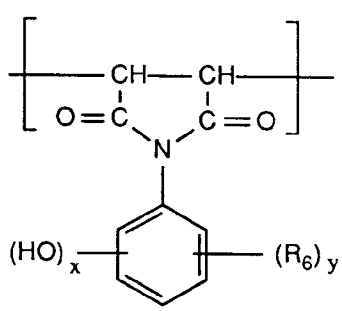

(IV)

worin $R_6$ $C_1$-$C_4$-Alkyl, $C_1$-$C_4$-Alkoxy oder Halogen, insbesondere Chlor oder Brom ist, x 1, 2 oder 3 darstellt, y 0, 1, 2, 3 oder 4 ist und die Summe von x und y höchstens 5 bedeutet, wobei die Reste $R_6$ eines Phenylkernes innerhalb der gegebenen Definitionen unterschiedlich sein können.

Bedeuten $R_3$, $R_4$, $R_6$ oder $R_6$ $C_1$-$C_4$-Alkyl, so handelt es sich dabei um geradkettige oder verzweigte, bevorzugt um geradkettige, Alkylreste. Beispiele für solche Gruppen sind Methyl, Ethyl, n-Propyl, Isopropyl, n-Butyl oder sek.Butyl. Bevorzugt wird Methyl.

Als $C_1$-$C_4$-Alkoxy besitzt der Alkylteil von $R_3$, $R_4$, $R_5$ oder $R_6$ die oben beispielhaft erwähnten Bedeutungen. Bevorzugt wird Methoxy.

Als Halogen sind $R_3$, $R_4$, $R_5$ oder $R_6$ Fluor, Chlor, Brom oder Iod. Bevorzugt wird Chlor oder Brom, insbesondere Brom.

Der Index x im Strukturelement der Formel IV ist vorzugsweise 1 oder 2, besonders bevorzugt 1. Der Index y im Strukturelement der Formel IV ist vorzugsweise 0,1 oder 2, besonders bevorzugt 0.

Eine weitere bevorzugte Gruppe von Bindemitteln des Typs iii) sind Copolymere auf der Basis von N-Hydroxyphenylmaleinimiden, insbesondere solche mit Strukturelementen der Formel IV und carboxylgruppenfreien Verbindungen.

Beispiele für geeignete Vinyl-Comonomere sind:

A) Styroltypen, wie beispielsweise Styrol, $\alpha$-Methylstyrol, p-Methylstyrol oder p-Hydroxyphenylstyrol;

B) Ester oder Amide $\alpha,\beta$-ungesättigter Säuren, wie beispielsweise Acrylsäuremethylester, Acrylsäureamid, die entsprechenden Methacrylverbindungen oder Maleinsäuremethylester,

C) Nitrile von $\alpha,\beta$-ungesättigten Säuren, wie beispielsweise Acrylnitril oder Methacrylnitril;

D) halogenhaltige Vinylverbindungen, wie beispielsweise Vinylchlorid, Vinylfluorid, Vinylidenchlorid oder Vinylidenfluorid;

E) Vinylester, wie beispielsweise Vinylacetat oder

F) Vinylether, wie beispielsweise Mehylvinylether oder Butylvinylether.

Der Anteil der Vinylkomponente beträgt in der Regel 0 bis 95 Mol%, bevorzugt 0-75 Mol%, besonders bevorzugt 0-50 Mol%, bezogen auf den Gesamtanteil an Monomereinheiten.

Homopolymere aus Struktureinheiten der Formel IV und Copolymere mit Vinylverbindungen sind bekannt und werden beispielsweise in der BE-A 613,801 sowie in Kobunshi Kagaku 26, 593-601 (1969) (Chem. Abstr. 72, 21964n) beschrieben.

Eine weitere besonders bevorzugte Gruppe von Bindemitteln des Typs iii) sind Copolymere auf der Basis von N-Hydroxymaleinimiden, insbesondere solche mit Strukturelementen der Formel IV, Allylverbindungen und gegebenenfalls weiteren Vinylverbindungen.

Zusätzliche Bindemittel des Typs iii) sind in der EP-A 0 255 989 beschrieben.

Besonders bevorzugt verwendet man als Bindemittel a) einen Novolak, bevorzugt einen Phenol- oder Kresolnovolak, und insbesondere Bindemittel des Typs ii), vor allem Homo- und Copolymere von Hydroxystyrolen. Ganz besonders bevorzugt sind handelsübliche Poly(p-hydroxystyrole). Diese weisen im allgemeinen ein Molekulargewicht (Mw) von 1000 bis 100'000, gemessen mittels Gelpermeationschromatographie, besonders von 4000 bis 25000, auf.

Als Verbindungen c), die unter aktinischer Strahlung Säure bilden, kommen insbesondere Oniumsalze, wie Diazonium-, Sulfonium-, Sulfoxonium- und Iodoniumsalze in Betracht. Bevorzugt sind Sulfoniumsalze der Formel V.

$$(Ar_1)_q(R_7)_r(R_8)_s\ S^{\oplus}X^{\ominus} \qquad (V),$$

worin

$Ar_1$ unsubstituiertes oder durch Halogen, $C_1$-$C_4$-Alkyl, $C_1$-$C_4$-Alkoxy, -OH und/oder Nitro substituiertes Phenyl, Naphthyl oder Phenyl-$COCH_2$- ist,

$R_7$ $C_1$-$C_4$-Alkyl oder $C_3$-$C_7$-Cycloalkyl und

$R_8$ Tetrahydrothienyl, Tetrahydrofuryl oder Hexahydropyryl sind,

q für 0, 1, 2 oder 3,

r für 0, 1 oder 2 und

s für 0 oder 1 stehen, wobei die Summe q+r+s 3 beträgt, und

$X^{\ominus}$ ein Chlorid-, Bromid- oder Iodidanion, $BF_4^{\ominus}$ , $PF_6^{\ominus}$, $AsF_6^{\ominus}$, $SbF_6^{\ominus}$, $FSO^{\ominus}$ oder das Anion einer organischen Sulfonsäure oder Carbonsäure ist.

Phenyl-, Naphthyl- und Phenacylgruppen $Ar_1$ sind bevorzugt einfach substituiert, insbesondere durch Cl, Br, Methyl, Methoxy, -OH oder Nitro. Besonders bevorzugt sind diese Reste unsubstituiert. $R_7$ ist vorzugsweise $C_1$-$C_4$-Alkyl, insbesondere Methyl oder Ethyl. Bevorzugt sind q 2 oder 3, r 1 oder Null und s Null, insbesondere ist q = 3 und r und s sind Null. Ganz besonders bevorzugt ist $Ar_1$ unsubstituiertes Phenyl und q ist 3.

Stellt $X^{\ominus}$ das Anion einer organischen Sulfonsäure oder Carbonsäure dar, so kann es sich um Anionen von aliphatischen, cycloaliphatischen, carbocyclisch-aromatischen, heterocyclisch-aromatischen oder araliphatischen Sulfon- oder Carbonsäuren handeln. Diese Anionen können substituiert oder unsubstituiert sein. Bevorzugt sind Sulfon- und Carbonsäure mit geringer Nucleophilie, beispielsweise teil- oder perfluorierte Derivate oder in Nachbarstellung zur jeweiligen Säuregruppe substituierte Derivate. Beispiele für Substituenten sind Halogen, wie Chlor oder besonder Fluor, Alkyl, wie Methyl, Ethyl oder n-Propyl, oder Alkoxy, wie Methoxy, Ethoxy, oder n-Propoxy.

Beispiele für aliphatische Sulfonsäuren sind Methan-, Ethan-, n-Propan-, n-Butan- und n-Hexansulfonsäure oder die entsprechenden teil- oder perfluorierten Derivate.

Beispiele für aliphatische Carbonsäuren sind Ameisensäure, Essigsäure, Propionsäure, Buttersäure, Pivalinsäure, Capronsäure, 2-Ethylhexylcarbonsäure und Fettsäuren, wie Laurinsäure, Myristinsäure oder Stearinsäure, sowie die teil- oder perfluorierten Derivate dieser Säuren.

Beispiele für cycloaliphatische Sulfon- oder Carbonsäuren sind Cyclohexansulfonsäure, Cyclohexancarbonsäure, Campher- 10-sulfonsäure oder deren teil- oder perfluorierte Derivate.

Beispiele für carbocyclisch-aromatische Sulfonsäuren sind Benzol-, Toluol-, Ethylbenzol-, Isopropylbenzol-, Dodecylbenzol- oder Dimethylbenzolsulfonsäure, 2,4,6-Triisopropylbenzolsulfonsäure, 2,4,6-Trimethylbenzolsulfonsäure, Naphthalinsulfonsäure, -disulfonsäuren oder -trisulfonsäuren und die entsprechenden alkylierten oder teil- oder perfluorierten Derivate dieser Sulfonsäuren.

Beispiele für heterocyclisch-aromatische Sulfonsäuren sind Pyridin-, Thiophen- oder Pyrrolsulfonsäure und die entsprechenden teil- oder perfluorierten Derivate dieser Säuren.

Beispiele für araliphatische Sulfonsäuren sind Benzylsulfonsäure, $\alpha$-Methylbenzylsulfonsäure und die ent-

sprechenden teil- oder perfluorierten Derivate dieser Verbindungen.

Beispiele für carbocyclisch-aromatische Carbonsäuren sind Benzoesäure, Toluol-, Ethylbenzol-, Isopropylbenzol- oder Dimethylbenzolcarbonsäure, Naphthalincarbonsäure oder Anthracencarbonsäure und die entsprechenden teil- oder perfluorierten Derivate dieser Verbindungen.

Beispiele für heterocyclisch-aromatische Carbonsäuren sind Pyridin-, Thiophen- oder Pyrrolcarbonsäure sowie die entsprechenden teil- oder perfluorierten Derivate dieser Verbindungen.

Beispiele für araliphatische Carbonsäuren sind Benzylcarbonsäure, $\alpha$-Methylbenzylcarbonsäure und Zimtsäure, sowie die entsprechenden teil- oder perfluorierten Derivate dieser Verbindungen.

Vorzugsweise handelt es sich bei $X^{\ominus}$ um das einwertige Anion einer organischen Sulfonsäure, insbesondere einer Teilfluor- oder Perfluorsulfonsäure. Diese Anionen zeichnen sich durch eine besonders geringe Nucleophilie aus.

Spezielle Beispiele für geeignete Sulfoniumsalze der Formel V sind Triphenylsulfoniumbromid, Triphenylsulfoniumchlorid, Triphenylsulfoniumiodid, Triphenylsulfoniumhexafluorphosphat, Triphenylsulfoniumhexafluorantimonat, Triphenylsulfoniumhexafluorarsenat, Triphenylsulfoniumtrifluormethansulfonat, Diphenylethylsulfoniumchlorid, Phenacyldimethylsulfoniumchlorid, Phenacyltetrahydrothiopheniumchlorid, 4-Nitrophenacyltetrahydrothiopheniumchlorid und 4-Hydroxy-2-methylphenylhexahydrothiopyryliumchlorid. Besonders bevorzugt ist Triphenylsulfoniumtriflourmethansulfonat.

Als Verbindungen c) können auch Iodoniumsalze der Formel VI.

$$[Ar_2\text{-}I^{\oplus}\text{-}Ar_3]\ X_1^{\ominus} \qquad \text{(VI)}$$

verwendet werden, worin

$Ar_2$ und $Ar_3$ unabhängig voneinander unsubstituiertes oder durch $C_1$-$C_4$-Alkyl, $C_1$-$C_4$-Alkoxy, Halogen und/oder Nitro substituiertes Phenyl oder Naphthyl sind oder $Ar_2$ oder $Ar_3$ zusammen eine Gruppe der Formel VII

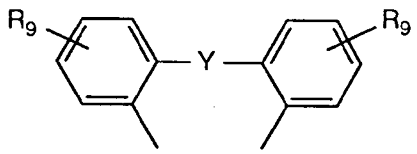

(VII)

darstellen, worin $R_9$ $C_1$-$C_4$-Alkyl, $C_1$-$C_4$-Alkoxy, Halogen oder Nitro und Y eine Direktbindung, -O-, $-CH_2$- oder -CO- darstellen und

$X_1^{\ominus}$ ein Chlorid-, Bromid- oder Iodidanion bedeutet.

Iodoniumsalze der Formel VI sind z.B. in der GB-A 1539 192 beschrieben.

Als Verbindungen c) eignen sich auch unter aktinischer Strahlung Sulfonsäure erzeugende Substanzen der Formeln VIII bis XIV

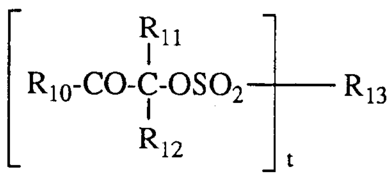

(VIII),

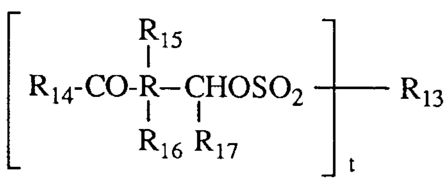

(IX),

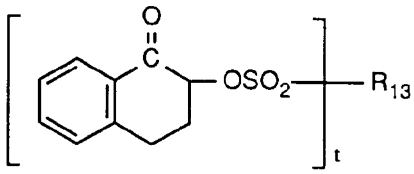

(X),

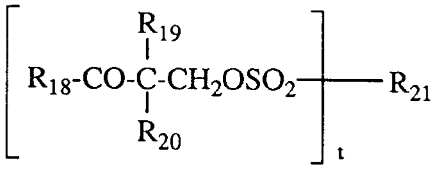

(XI),

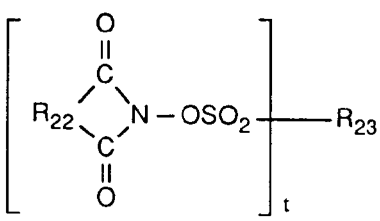

(XII)

$[R_{24}CON(R_{20})\text{-}OSO_2]_t\text{-}R_{23}$ (XIII) und

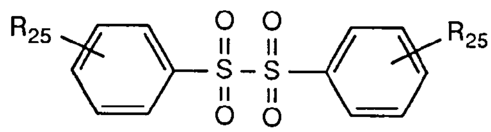

(XIV),

worin t 1 oder 2, bevorzugt 1 ist,

$R_{10}$ unsubstituiertes oder durch 1-3 -Cl, -Br, -CN, $-NO_2$, $C_1$-$C_4$-Alkyl, $C_1$-$C_4$-Alkoxy, $C_1$-$C_4$-Alkylthio, Phenoxy, Phenylthio, $C_1$-$C_4$-Alkylamino, $C_2$-$C_4$-Dialkylamino oder Benzoyl substituiertes Phenyl oder Naphthyl, besonders unsubstituiertes oder einfach durch -Cl, Methyl oder Methoxy substituiertes Phenyl darstellt,

$R_{11}$ Wasserstoff oder $C_1$-$C_4$-Alkyl und

$R_{12}$ Wasserstoff, $C_1$-$C_4$-Alkyl oder Phenyl bedeuten oder

$R_{11}$ und $R_{12}$ zusammen mit dem Bindungs-C-Atom einen Cyclopentan- oder Cyclohexanring bilden,

$R_{13}$, bei t = 1, $C_1$-$C_{18}$-Alkyl, unsubstituiertes oder durch $C_1$-$C_4$-Alkyl substituiertes Phenyl oder Naphthyl, Cyclopentyl, Cyclohexyl oder Campheryl und bei t = 2 $C_2$-$C_8$-Alkylen oder Phenylen bedeuten,

$R_{14}$ unsubstituiertes oder durch 1-3 -Cl, -Br, $C_1$-$C_4$-Alkyl, $C_1$-$C_4$-Alkoxy, $C_1$-$C_4$-Alkylthio, Phenyl, Phenoxy, Phenylthio, $C_1$-$C_4$-Alkyl-CONH-, Benzoylamino,

Dimethylamino substituiertes Phenyl oder Naphthyl, besonders unsubstituiertes oder einfach durch -Cl, $C_1$-$C_4$-Alkoxy, Methylthio oder Phenyl substituiertes Phenyl ist, $R_{15}$ -OH oder $C_1$-$C_4$-Alkyl ist,

$R_{16}$ $C_1$-$C_4$-Alkyl oder Phenyl ist,

$R_{17}$ Wasserstoff, $C_1$-$C_4$-Alkyl, Furyl oder $-CCl_3$ bedeutet oder

$R_{16}$ und $R_{17}$ zusammen mit dem Bindungs-C-Atom einen Cyclopentan- oder Cyclohexanring bilden,

$R_{18}$ und $R_{19}$ unabhängig voneinander unsubstituiertes oder durch Halogen, $C_1$-$C_4$-Alkyl oder $C_1$-$C_4$-Alkoxy substituiertes Phenyl sind,

$R_{20}$ Wasserstoff oder $C_1$-$C_4$-Alkyl darstellt,

$R_{21}$ bei t = 1, $C_1$-$C_6$-Alkyl, Phenyl, Naphthyl oder Benzyl und bei t = 2 $C_1$-$C_6$-Alkylen, Phenylen oder Xylylen darstellt,

$R_{22}$ unsubstituiertes oder durch Halogen, Nitro, $C_1$-$C_4$-Alkyl, $C_1$-$C_4$-Alkoxy oder $C_1$-$C_4$-Alkylthio substituiertes Phenylen oder Naphthylen oder -CH = CH- ist,
$R_{23}$ bei t = 1 $C_1$-$C_{12}$-Alkyl, unsubstituiertes oder durch Halogen, Nitro, $C_1$-$C_4$-Alkyl oder $C_1$-$C_4$-Alkoxy substituiertes Phenyl und bei t = 2 $C_2$-$C_8$-Alkylen oder Phenylen ist, $R_{24}$ unsubstituiertes oder durch Halogen, Nitro, -CN, $C_1$-$C_4$-Alkyl, Methoxy, Ethoxy, Dimethylamino oder Benzoyl substituiertes Phenyl oder Naphthyl bedeutet und die $R_{25}$ unabhängig voneinander $C_1$-$C_4$-Alkyl sind.

Definitionsgemässe Alkyl-, Alkoxy-, Alkylthio-, Alkylamino-, Dialkylamino- Alkylcarbamoyl- und Alkylengruppen können geradkettig oder verzweigt sein, sind aber bevorzugt geradkettig. Halogen bedeutet insbesondere -Cl oder -Br.

Verbindungen der Formel VIII bis XIII sind z.B. in den EP-A 0166 682 und 0 085 024 sowie der darin zitierten Literatur beschrieben. Besonders bevorzugte Verbindungen der Formeln VIII bis XIII sind Phenacyl-p-methylbenzolsulfonat, Benzoin-p-toluolsulfonat, 3-(p-Toluolsulfonyloxy)-2-hydroxy-2-phenyl-1-phenyl-1-propanon [α-(p-Toluolsulfonyloxy)methylbenzoin], N-(p-Dodecylbenzolsulfonyloxy)- 1,8-naphthalimid und N-(Phenylsulfonyloxy)- 1,8-nahphthalimid.

Weitere geeignete Verbindungen c) sind o-Nitrobenzaldehyde, die sich unter aktinischer Bestrahlung in o-Nitrosobenzoesäuren umlagern, wie 1-Nitrobenzaldehyd und 2,6-Dinitrobenzaldehyd; α-Halogenacylphenone, wie α,α,α-Trichloracetophenon und p-tert.Butyl-α,α,α-trichloracetophenon, sowie Sulfonsäureester von o-Hydroxyacylphenonen, wie 2-Hydroxybenzophenonmethansulfonat und 2,4-Hydroxybenzophenon-bis-(methansulfonat).

Schliesslich eignen sich als Verbindungen c) auch solche, die aromatisch gebundenes Chlor oder Brom enthalten, wie sie beispielsweise in der EP-A 0 318 649 beschrieben sind, z.B. Verbindungen der Formel XV

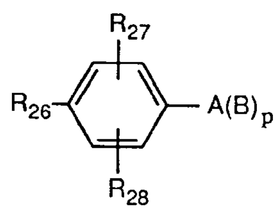

(XV)

mit mindestens einem aromatisch gebundenen Chlor- oder Bromatom, worin z.B. p 0 oder 1 bedeutet,
$R_{26}$ -COOH, -$OR_{29}$ oder -$SR_{29}$ ist, $R_{27}$ und $R_{28}$ unabhängig voneinander Wasserstoff, -Cl, -Br, gegebenenfalls durch Aryl, Alkoxy, Aryloxy, -OH oder -F substituiertes Alkyl oder gegebenenfalls durch Alkoxy, Aryloxy, -OH oder Halogen substituiertes Aryl sind,
$R_{29}$ Wasserstoff, gegebenenfalls analog $R_{27}$ substituiertes Alkyl oder Aryl oder Acyl ist,
A bei p = 0, Wasserstoff, -Cl, -Br, gegebenenfalls analog zu $R_{27}$ substituiertes Alkyl und bei p = 1, -$SO_2$-, Propylen oder Perfluoralkylen ist und
B eine Gruppe

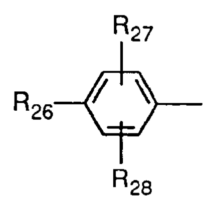

,

Alkylcarbonyl, Alkoxycarbonyl oder substituiertess ulfonylimidocarbonyl bedeutet.

Beispiele derartiger Verbindungen sind Hexafluortetrabrom-Bisphenol A,1,1,1-Tris-(3,5-dibrom-4-hydroxyphenyl)ethan und N-(2,4,6-Tribromphenyl)-N'-(p-toluolsulfonyl)harnstoff.

Besonders bevorzugt verwendet man als Verbindungen c) solche der Formel V, worin $Ar_1$ Phenyl bedeutet, q die Zahl 3 ist und $X^{\ominus}$ $SbF_6^{\ominus}$, $PF_6^{\ominus}$ und insbesondere das Anion einer aliphatischen, teilfluoraliphatischen oder perfluoraliphatischen Sulfonsäure oder einer aromatischen, teilfluoraromatischen oder perfluoraromatischen Sulfonsäure ist. Besonders bevorzugte Anionen $X^{\ominus}$ sind $CF_3SO_3^{\ominus}$, $C_2F_5SO_3^{\ominus}$, n-$C_3F_7SO_3^{\ominus}$, n-$C_4F_9SO_3^{\ominus}$, n-$C_6F_{13}SO_3^{\ominus}$, n-$C_8F_{17}SO_3^{\ominus}$ und $C_6F_5SO_3^{\ominus}$. Ganz besonders bevorzugt verwendet man als Verbindung c) Triphenylsulfoniumtrifluormethansulfonat.

Die Verbindungen c) werden zweckmässig i einer Menge von 1 bis 30 Gew.%, besonders 1 bis 20 Gew.% und ganz besonders 1 bis 10 Gew.%, bezogen auf a) + b), eingesetzt.

Die erfindungesgemässen Zusammensetzungen können weitere übliche Zusatzstoffe enthalten, wie z.B. Stabilisatoren, Pigmente, Farbstoffe, Füllstoffe, Haftvermittler, Verlaufmittel, Netzmittel und Weichmacher. Bevorzugt sind die Zusammensetzungen zur Applikation in geeigneten Lösungsmitteln [Komponente d)] gelöst werden.

Die in einem Lösungsmittel oder Lösungsmittelgemisch gelösten erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie Metalle, wie Al, Cu, Ni, Fe, Zn, Mg oder Co, und GaAs, Si oder $SiO_2$, auf denen durch bildmässiges Belichten eine Abbildung aufgebracht werden soll.

Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder entfernt werden können. Geeignete Lösungsmittel sind z.B. Ketone, Ether und Ester, wie Methylethylketon, Isobutylmethylketon, Cyclopentanon, Cyclohexanon, N-Methylpyrrolidon, Dioxan, Tetrahydrofuran, 2-Methoxyethanol, 2-Ethoxyethanol, 1-Methoxy-2-propanol, 1,2-Dimethoxyethan, Essigsäureethylester, Essigsäure-n-butylester und 3-Ethoxy-propionsäureethylester.

Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Roll-beschichtung. Es ist auch möglich, die lichtempfindliche Schicht auf einen temporären, flexiblen Träger zu bringen und dann durch Schichtiibetragung via Lamination das endgültige Substrat, z.B. eine kupferkaschierte Leiterplatte, zu beschichten.

Die Auftragsmenge (Schichtdicke) und die Art des Substrates (Schichtträger) sind vom gewünschten Applikationsgebiet abhängig. Der Schichtdickenbereich umfasst im allgemeinen Werte von ca. 0,1 µm bis mehr als 10 µm.

Die erfindungsgemässen strahlungsempfindlichen Zusammensetzungen finden Anwendung als Negativresist, die eine sehr hohe Lichtempfindlichkeit aufweisen und schwellungsfrei in wässrig-alkalischem Medium entwickelt werden können. Sie eignen sich als Photoresists für die Elektronik (Galvanoresist, Ätzresist, Lötstopresist), die Herstellung von Druckplatten, wie Offsetdruckplatten oder Siebdruckformen, den Einsatz beim Formteilätzen oder den Einsatz als Mikroresist bei der Herstellung integerter Schaltkreise. Dementsprechend unterschiedlich sind die möglichen Schichtträger und die Verarbeitungsbedingungen der beschichteten Substrate.

Für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen in der Regel ca. 0,5 µm bis 10 µm, für gedruckte Schaltungen 0,4 bis ca. 2 µm.

Mit den erfindungsgemässen Zusammensetzungen können hoch aufgelöste Reliefstrukturen negtiver Tonalität hergestellt werden. Dank der hohen Empfindlichkeit und der hohen optischen Transparenz bzw. der geringen optischen Absorption im UV-Bereich um 250 nm eignen sie sich insbesondere für Anwendungen in der Mikrolithographie, vor allem der Tief-UV-Mikrolithographie. Dank dieser Eigenschaften lassen sich sehr steile Wandprofile und die Auflösung von Submikronstrukturen (bis auf 0,5 µm) erzielen; derartige Submicronstrukturen können z.B. mit entsprechenden Zusammensetzungen enthaltend zwei Acetoxymethylfunktionen im Copolymermolekül nicht hergestellt werden.

Nach dem Beschichten der Substrate wird das Lösungsmittel in der Regel durch Trocknen entfernt, und es resultiert eine Schicht des Photoresists auf dem Träger.

Der Begriff "bildmässige" Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteten Substrates bewegt wird und auf diese Weise ein Bild. erzeugt, sowie die Bestrahlung mit computergesteuerten Elektronenstrahlen.

Die Lichtempfindlichkeit der erfindungsgemässen Zusammensetzungen reicht in der Regel vom UV-Gebiet (ca. 200 nm) bis ca. 600 nm und umspannt somit einen sehr breiten Bereich. Als Lichtquellen kommen daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen, erzeugt mittels Synchrotronen oder Laser-Plasma. Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Excimer-Laser, wie

Kripton-F-Laser zur Belichtung bei 248 nm. Hier ist die hohe Empfindlichkeit der erfindungsgemässen Materialien sehr vorteilhaft. Nach dieser Methode können gedruckte Schaltungen in der Elektronkindustrie, lithographische Offsetdruckplatten oder Reliefdruckplatten sowie photographische Bildaufzeichnungsmaterialien hergestellt werden.

Nach der bildmässigen Belichtung des Materials und vor der Entwicklung kann es vorteilhaft sein, für kürzere Zeit eine thermische Behandlung durchzuführen. Dabei werden nur die belichteten Teile thermisch gehärtet. Die angewandten Temperaturen liegen im allgemeinen bei 50-150 °C, bevorzugt bei 80-130°C; die Zeit für die thermische Behandlung liegt in der Regel zwischen 0,25 und 10 Minuten.

Nach der Belichtung und gegebenenfalls thermischen Behandlung werden die unbelichteten Stellen des Photolacks in an sich bekannter Weise mit einem Entwickler entfernt.

Die erfindungsgemässen Zusammensetzungen sind - wie schon erwähnt - wässrig-alkalisch entwickelbar. Geeignete wässrig-alkalische Entwickler-Lösungen sind insbesondere wässrige Lösungen von Tetraalkylammoniumhydroxiden oder von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein. Typische organische Lösungsmittel, die den Entwickleflüssigkeiten in kleinen Mengen zugesetzt werden können, sind beispielsweise Cyclohexanon, 2-Ethoxyethanol, Toluol, Aceton sowie Mischungen solcher Lösungsmittel. Die erfindungsgemässen Zusammensetzungen eignen sich insbesondere zur Herstellung von Druckplatten, gedruckten Schaltungen und integrierten Schaltkreisen.

Die folgenden Beispiele erläutern die Erfindung näher. Darin bedeuten Teile und Prozente Gewichtsteile bzw. Gewichtsprozente, sofern nichts anderes angegeben ist.

Beispiel 1-4: Herstellung von Verbindungen der Formel I

Beispiel 1: 2,2′-(1,4-Phenylen)bis-1,3-dioxolan

In einem 250 ml Rundkolben mit Magnetrührer und Wasserabscheider werden 7,24 g (54 mMol) Terephthalaldehyd, 7,45 g (120 mMol) Ethylenglykol und 0,2 g (1 mMol) p-Toluolsulfonsäure-monohydrat mit 100 ml Toluol versetzt. Man rückflussiert während 2 Stunden, kühlt ab und neutralisiert zweimal mit je 100 ml 0,1 N NaOH-Lösung. Die organische Phase wird dreimal mit je 50 ml Wasser gewaschen, über Magnesiumsulfat getrocknet und eingeengt. Das anfallende Produkt wird anschliessend aus Cyclohexan umkristallisiert, wobei 6,8 g (31 mMol, 58 % d.Th.) 2,2′-(1,4-Phenylen)bis- 1,3-dioxolan in Form weisser Kristalle erhalten werden; Smp. 86-89°C. $^{1}$H-NMR ($CDCl_3$, 100 MHz):
$\delta$ 7,49/s/4H, 5,84/s/2H, 4,06/m/8H. UV-Spektrum ($CH_2Cl_2$): $\varepsilon_{250nm}$=840.

| | | | |
|---|---|---|---|
| Elementaranalyse: | berechnet | C 64,85 % | H 6,35 % |
| | gefunden | C 61,79 % | H 6,33 %. |

Beispiel 2: 2,2′-(1,4-Phenylen)bis-1,3-dioxan

Analog der in Beipsiel 1 beschriebenen Arbeitsweise erhält man aus 7,24 g (54 mMol) Terephthalaldehyd, 9,13 g (120 mMol) 1,3-Propandiol und 0,2 g (1 mMol) p-Toluolsulfonsäure-monohydrat in 100 ml Toluol 9,9 g (39,6 mMol, 73 % d.Th.) 2,2′-( 1,4-Phenylen)bis- 1,3-dioxan; Smp. 164- 168°C.
$^{1}$H-NMR ($CDCl_3$, 100 MHz): $\delta$ 7,47/s/4H, 5,49/s/2H, 3,85-4,4/m/8H, 2,4-2,0/m/2H, 1,6- 1,3/m/2H.

| | | | |
|---|---|---|---|
| Elementaranalyse: | berechnet | C 67,18 % | H 7,25 % |
| | gefunden | C 66,10 % | H 7,24 %. |

Beispiel 3: 2,2′-(1,4-Phenylen)-bis- 1,3-(5,5′-dimethyl)dioxan

In einem 500 ml Rundkolben mit Wasserabscheider werden 15,0 g (111 mMol) Terephthalaldehyd, 25,6 g (246 mMol) 2,2-Dimethyl-1,3-propandiol und 0,4 g (2 mMol) p-Toluolsulfonsäure-monohydrat mit 200 ml Toluol versetzt. Nach 4-stündigem Kochen unter Rückfluss lässt man abkühlen, filtriert und kristallisiert aus Methanol um, wobei 10,2g (33 mMol) 2,2′-(1,4-Phenylen)bis-1,3-(5,5′-dimethyl)-dioxan in Form blättchenförmiger Kristalle erhalten werden; Smp. 205-206°C. $^{1}$H-NMR, ($CDCl_3$ 300 MHz); $\delta$ 7,52/s/4H, 5,39/s/2H, 3,75/d/4H,

3,65/d/4H, 1,27/s/6H, 0, 81/s/6H.

Beispiel 4: 1,4-Bis(dipropoxymethyl)-benzol

In einem 500 ml Rundkolben mit Wasserabscheider werden 26,8 g (200 mMol) Terephthalaldehyd, 52,9 g (880 mMol) 1-Propanol und 0,5g (0,25 mMol) p-Toluolsulfonsäure-monohydrat in 200 ml Benzol gelöst. Man rückflussiert während 3 Stunden, lässt abkühlen und wäscht das Reaktionsgemisch einmal mit 200 ml 1 N Natriumhydroxydlösung und danach zweimal mit Wasser. Die organische Phase wird über Magnesiumsulfat getrocknet und eingeengt. Man erhält 40,1 g (118 mMol, 59 % d.Th.) 1,4-Bis(dipropoxymethyl)-benzol in Form eines klaren Öls, das sich destillativ reinigen lässt.
$^1$H-NMR ($CDCl_3$, 300 MHz): $\delta$ 7,90/d/2H, 7,65/d/2H, 5,57/s/1H, 5,52/s/1H, 3,47/m/8H, 1,65/m/8H, 0,95/m/12H.

Beispiele 5-10: Anwendungsbeispiele

Beispiel 5:

Es wird eine Resistmischung hergestellt durch Auflösen von 260 Teilen Poly(p-hydroxystyrol) [Fa. Maruzen Petrochem. Comp.], 40 Teilen 2,2′-(-1,4-Phenylen)bis-1,3-dioxolan und 10 Teilen Triphenylsulfoniumtrifluormethansulfonat in 600 Teilen Cyclohexanon. Die Resistlösung wird auf einen Siliziumwafer aufgeschleudert, wobei nach dem Trocknen bei 120°C während 2 Minuten ein Resistfilm einer Dicke von 1,0 µm erhalten wird. Anschliessend wird der Film durch eine Chrom-Quarz-Maske mit Engband-Interferenzfilter bei 254 nm mit einer Dosis von 10 mJ/cm$^2$ kontaktbelichtet. Danach wird während 20 Sekunden auf 130°C erwärmt und in einem metallionenfreien Entwickler auf der Basis einer 2,38%igen wässrigen Lösung von Tetramethylammoniumhydroxid während 1 Minute entwickelt, wobei die unbelichteten Stellen des Resistfilms vollständig in Lösung gehen. Das so erhaltene Resistmaterial erlaubt die Auflösung von 0,5 µm-Strukturen (isolierte Linien) mit einem Kantenwinkel von 92° und weist einen Kontrastwert $\gamma$ von 3 auf.

Beispiel 6:

Eine Resistformulierung aus 100 Teilen eines m-Kresol-Novolaks, 20 Teilen 2,2′-(1,4-Phenylen)bis- 1,3-dioxolan und 3,5 Teilen Triphenylsulfoniumtrifluormethansulfonat, gelöst in 350 Teilen Cyclopentanon, wird auf einen Siliziumwafer aufgeschleudert und bei 130°C während 2 Minuten getrocknet, wobei ein Resistfilm einer Dicke von 1,0 µm erhalten wird. Der Film wird während 5 Sekunden mit einer UXM-502 MD-Lampe der Fa. USHIO belichtet, dann während 30 Sekunden auf 110°C erhitzt und während 60 Sekunden mit einer 2,38%igen wässrigen Lösung von Tetramethylammoniumhydroxid entwickelt. Der Resist weist eine Empfindlichkeit von 2 mJ/cm$^2$ auf und erlaubt die Auflösung von Submikronstrukturen bis 0,75 µm l/s (l/s = lines and spaces) mit annähernd senkrechten Wandprofilen.

Beispiel 7:

Eine Resistformulierung bestehend aus 100 Teilen Poly(p-hydroxystyrol) der Fa. Maruzen Petrochem. Comp., 40 Teilen 2,2′-(1,4-Phenylen)-bis-1,3-dioxan und 13 Teilen Triphenylsulfoniumtrifluormethansulfonat, gelöst in 400 Teilen Cyclopentanon, wird auf einen Siliziumwafer aufgeschleudert und während 2 Minuten bei 120°C getrocknet, wobei ein homogener Resistfilm der Dicke 1,1 µm erhalten wird. Dieser Film wird bei einer Wellenlänge von 254 nm (Engbandfilter) bildmässig belichtet, dann während 30 Sekunden auf 120°C erwärmt und anschliessend in einer 2%igen Lösung von Tetramethylammoniumhydroxid in Wasser während 1 Minute entwickelt, wobei die unbelichteten Stellen des Resistfilms aufgelöst werden. Das Resistmaterial weist eine Empfindlichkeit von 30 mJ/cm$^2$ auf und ist in der Lage, Submikronstrukturen bis 0,5 µm (isolierte Linien) aufzulösen.

Beispiel 8:

Eine Resistformulierung bestehend aus 100 Teilen Poly(p-hydroxystyrol) der Fa. Maruzen Petrochem. Comp., 40 Teilen 2,2′-(1,4-Phenylen)-bis-1,3-dioxan und 10 Teilen der Verbindung der Formel

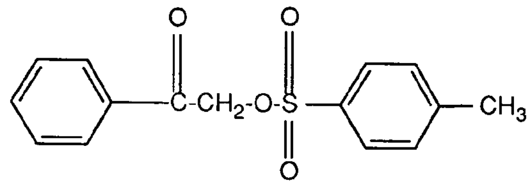

(Phenacyl-p-methylbenzolsulfonat) gelöst in 400 Teilen Cyclohexanon, wird auf einen Siliziumwafer aufgeschleudert und während 2 Minuten bei 120°C getrocknet, wobei ein homogener Resistfilm mit einer Dicke von 1,0 µm erhalten wird. Nach Kontaktbelichtung (30 $mJ/cm^2$) durch eine Quarzmaske mit Engbandfilter bei 254 nm wird während 1 Minute auf 120°C erwärmt und anschliessend mit einer 1,6%igen Lösung von Tetramethylammoniumhydroxyd in Wasser entwickelt. Mit dem erhaltenen Resistmaterial können Submikronstrukturen bis 0,75 µm (isolierte Linien) aufgelöst werden.

Beispiel 9:

Auf eine kupferkaschierte Leiterplatte wird durch Aufpinseln der Resistformulierung gemäss Beispiel 6 und anschliessende Trocknung im Wärmeschrank ein Resistfilm von 30 µm Dicke aufgebracht und im Wärmeschrank während 1 Stunde bei 70°C getrocknet. Danach wird während 10 Sekunden durch eine Maske mit einer UXM-502 MD-Lampe der Firma Ushio bildmässig belichtet. Nach dem Erwärmen auf 120°C während 30 Sekunden wird mit 0,5 N-Natriumhydroxidlösung entwickelt, wobei die unbelichteten Stellen des Films aufgelöst werden, die belichteten Stellen dagegen als Reliefstrukturen der ursprünglichen Dicke erhalten bleiben.

Beispiel 10

Durch Auflösen von 100 Teilen Poly(p-hydroxystyrol) der Fa. Maruzen Petrochem. Comp., 40 Teilen 1,4-Bis (dipropoxymethyl)-benzol und 10 Teile Triphenylsulfoniumtrifluormethansulfonat in 400 Teilen Cyclohexanon wird eine Resistlösung hergestellt. Diese wird auf einen Siliziumwafer aufgeschleudert und bei 100°C während 1 Minute getrocknet, wobei ein homogener Film mit einer Dicke von 1,5 µm erhalten wird. Die bildmässige Belichtung erfolgt durch eine Quarzmaske mit einer Quecksilberdampflampe während 10 Sekunden. Anschliessend wird während 1 Minute auf 120°C erhitzt und danach in 1 N Natriumhydroxydlösung entwickelt, wobei die unbelichteten Stellen des Films aufgelöst werden.

## Patentansprüche

1. Strahlungsempfindliche Zusammensetzung enthaltend
   a) mindestens ein festes filmbildendes Polyphenol,
   b) mindestens eine Verbindung der Formel I

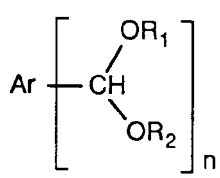

(I),

worin
n 2, 3 oder 4 darstellt,
Ar ein n-wertiger Benzol- oder Naphthalinrest oder ein zweiwertiger Rest der Formel II

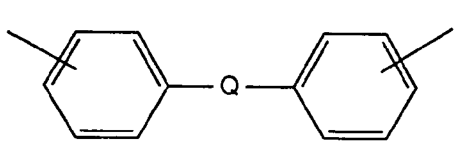

(II) ist,

Q die direkte Bindung, -O-, -SO-, $-SO_2-$, $-CH_2-$, $-C(CH_3)$(Phenyl)- oder $-C(CH_3)_2-$ ist, $R_1$ und $R_2$ unabhängig voneinander $C_1$-$C_8$-Alkyl oder unsubstituiertes oder durch $C_1$-$C_4$-Alkyl substituiertes Phenyl oder Naphthyl bedeuten oder $R_1$ und $R_2$ zusammen 1,2-Phenylen oder $-[C(R')(R'')]_m-$ darstellen, R′ und R″ unabhängig voneinander Wasserstoff, $C_1$-$C_4$-Alkyl oder Phenyl sind und m 2, 3 oder 4 ist, und.
c) mindestens eine unter aktinischer Strahlung säurebildende Verbindung.

2. Zusammensetzung nach Anspruch 1, worin n 2 ist und Ar 1,3-Phenylen und insbesondere 1,4-Phenylen darstellt.

3. Zusammensetzung nach Anspruch 1, worin $R_1$ und $R_2$ in Formel I dieselbe Bedeutung haben und insbesondere $C_1$-$C_4$-Alkyl darstellen.

4. Zusammensetzung nach Anspruch 1, worin $R_1$ und $R_2$ in Formel I zusammen 1,2-Phenylen und insbesondere $-[C(R')(R'')]_m-$ mit R′ und/oder R″ = H oder Methyl und m = 2 oder 3 darstellen.

5. Zusammensetzung nach Anspruch 1, worin die Komponente b) in einer Menge von 5-50 Gew.%, bevorzugt 10-30 Gew.%, bezogen auf die Komponente a), vorliegt.

6. Zusammensetzung nach Anspruch 1, enthaltend als weitere Komponente d) ein Lösungsmittel oder Lösungsmittelgemisch.

7. Zusammensetzung nach Anspruch 1, worin die Komponente a) ein Homo- oder Copolymer mit wiederkehrenden Strukturelementen der Formel III

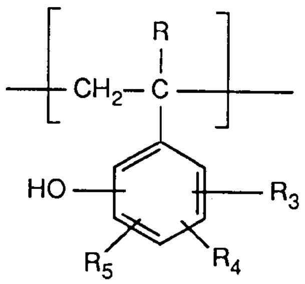

(III) ist,

worin R Wasserstoff oder Methyl ist, $R_3$, $R_4$ und $R_5$ unabhängig voneinander Wasserstoff, $C_1$-$C_4$-Alkyl, $C_1$-$C_4$-Alkoxy, Halogen oder Methylol bedeuten.

8. Zusammensetzung nach Anspruch 1, worin die Komponente a) ein Novolak, insbesondere ein Phenol- oder Kresolnovolak ist.

9. Zusammensetzung nach Anspruch 1, worin die Komponente a) ein Poly(p-hydroxystyrol) ist.

10. Zusammensetzung nach Anspruch 1, worin die Komponente c) eine Verbindung der Formel V.

$$(Ar_1)_q(R_7)_r(R_8)_sS^{\oplus}X^{\ominus} \quad (V) \quad \text{ist,}$$

worin

R $Ar_1$ unsubstituiertes oder durch Halogen, $C_1$-$C_4$-Alkyl, $C_1$-$C_4$-Alkoxy, -OH und/oder.
Nitro substituiertes Phenyl, Naphthyl oder Phenyl-$COCH_2$- ist,
$R_7$ $C_1$-$C_6$-Alkyl oder $C_3$-$C_7$-Cycloalkyl und
$R_8$ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
$X^{\ominus}$ ein Chlorid-, Bromid- oder Iodidanion, $BF_4^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist.

11. Zusammensetzung nach Anspruch 10, worin $Ar_1$ Phenyl bedeutet, q die Zahl 3 ist, r und s Null sind und $X^{\ominus}$ $SbF_6^{\ominus}$, $AsF_6^{\ominus}$, $PF_6^{\ominus}$ und insbesondere das Anion einer aliphatischen, teilfluoraliphatischen oder perfluoraliphatischen Sulfonsäure oder einer aromatischen, teilfluoraromatischen oder perfluoraromatischen

Sulfonsäure ist.

12. Zusammensetzung nach Anspruch 10, worin $Ar_1$ Phenyl bedeutet, q die Zahl 3 ist, r und s Null sind und $X^{\ominus}$ $CF_3SO_3^{\ominus}$, $C_2F_5SO_3^{\ominus}$, n-$C_3F_7SO_3^{\ominus}$, n-$C_4F_9SO_3^{\ominus}$, n-$C_6F_{13}SO_3^{\ominus}$, n-$C_8F_{17}SO_3^{\ominus}$ oder $C_6F_5SO_3^{\ominus}$ darstellt.

13. Zusammensetzung nach Anspruch 10, worin die komponente c) Phenacyl-p-methylbenzolsulfonat und insbesondere Triphenylsulfoniumtrifluormethansulfonat ist.

14. Zusammensetzung nach Anspruch 1, worin die komponente c) in einer Menge von 1 bis 30 Gew.%, besonders 1 bis 10 Gew.%, bezogen auf die komponenten a) + b), vorliegt.

15. Verwendung der strahlungsempfindlichen Zusammensetzung nach Anspruch 1 zur Herstellung von Schutzschichten und Reliefstrukturen, insbesondere zur Herstellung von Druckplatten, gedruckten Schaltungen und integrierten Schaltkreisen.

Europäisches Patentamt

# EUROPÄISCHER RECHERCHENBERICHT

Nummer der Anmeldung

EP 92 81 0124

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | DE-A-2 342 068 (FUJI PHOTO FILM CO LTD)<br>* Seite 24 - Seite 25; Ansprüche *<br>--- | 1 | G03F7/004<br>G03F7/038 |
| A | JOURNAL OF THE ELECTROCHEMICAL SOCIETY.<br>Bd. 136, Nr. 5, Mai 1989, MANCHESTER, NEW HAMPSHIRE US<br>Seiten 1453 - 1456;<br>CRIVELLO J.V.: 'Novel negative working photoresists'<br>* das ganze Dokument *<br>--- | 1 | |
| A | EP-A-0 342 498 (BASF AG)<br>* Seite 5, Absatz 4; Ansprüche *<br>--- | 1-15 | |
| A | EP-A-0 361 907 (HOECHST CELANESE CORPORATION)<br>* das ganze Dokument *<br>--- | 1-15 | |
| D,A | EP-A-0 255 989 (CIBA-GEIGY)<br>* Ansprüche *<br>----- | 1-15 | |
| | | | **RECHERCHIERTE SACHGEBIETE (Int. Cl.5 )** |
| | | | G03F |

Der vorliegende Recherchenbericht wurde für alle Patentansprüche erstellt

| Recherchenort | Abschlußdatum der Recherche | Prüfer |
|---|---|---|
| DEN HAAG | 11 JUNI 1992 | LUDI M.M.B. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)